# EUROPEAN PATENT APPLICATION

(11) **EP 3 606 301 A1**
(43) Date of publication of application: **05.02.2020**
(21) Application number: 17905614.8
(22) Date of filing: 10.04.2017
(51) Int. Cl.: H05K 3/20

(54) **CIRCUIT BOARD PRODUCTION METHOD, CIRCUIT SHEET AND CIRCUIT BOARD**

(71) Applicant: Hitachi Chemical Company, Ltd., Chiyoda-ku Tokyo 100-6606 (JP)
(72) Inventor: NISHIYAMA, Tomoo, Tokyo 100-6606 (JP); TOGAWA, Mitsuo, Tokyo 100-6606 (JP); TAKEZAWA, Yoshitaka, Tokyo 100-6606 (JP); NAKAMURA, Yuki, Tokyo 100-6606 (JP); KIGUCHI, Kazuya, Tokyo 100-6606 (JP); MIYAZAKI, Yasuo, Tokyo 100-6606 (JP); AMANUMA, Shinji, Tokyo 100-6606 (JP)
(74) Representative: Hoffmann Eitle
(86) International application number: PCT/JP2017/014725
(87) International publication number: WO 2018/189797

(57) **Abstract**

A circuit board production method, the method comprising a process of disposing a circuit sheet on a substrate, the circuit sheet comprising circuits and a resin portion disposed at spaces between the circuits.

## Description

### [Technical Field]

The invention relates to a circuit board production method, a circuit sheet and a circuit board.

### [Background Art]

With the progress of downsizing and sophistication of electronic devices, printed-circuit boards are widely used as circuit boards on which electronic components can be mounted at high density. Printed-circuit boards are generally manufactured by laminating a metal foil onto a board and etching the metal foil to form a desired circuit shape.

As the applications of electronic devices become diversified, increase in current capacity is desired for circuit boards. It is possible to increase the current capacity by enlarging the cross-section area of the circuit (conductor). However, there are technical difficulties in increasing the thickness of the circuit formed by etching, for example, the cross-section of the circuit becomes tapered and it is difficult to ensure insulation between the circuits, and the time for circuit processing becomes longer in proportion to the thickness increasing. Therefore, in a method of forming a circuit by etching, it is necessary to increase the width of the circuit, rather than the thickness, in order to enlarge the cross-section area of the circuit. As a result, it may be difficult to meet the demand for downsizing of circuit boards.

As a method of increasing the current capacity while achieving the downsizing of circuit boards, use of a metal member that is processed in advance in a circuit has been proposed (see, for example, Patent Documents 1, d and 3).

### [Prior Art Documents]

### [Patent Document]

[Patent Document 1] Japanese Patent Application Laid-Open No. 2014-99574
[Patent Document 2] Japanese Patent Application Laid-Open No. 2001-36201
[Patent Document 3] International Publication No. WO2009/110376
[Patent Document 4] Japanese Patent Application Laid-Open No. 2002-33558

### [Summery of the Invention]

### [Problem to be Solved by the Invention]

In the method described in Patent Document 1, a substrate having a layered structure is prepared by disposing an insulation layer between a metal plate, which is processed into a circuit, and a heat spreader. Thereafter, spaces between the circuits are filled with a resin. In this method, however, a circuit board is formed by attaching a lead frame, which is not in a planar form, to the insulation layer, dislocation of the circuit due to irregularity in pressure applied for the attachment may occur, thereby affecting the insulating property of the metal substrate that needs to be highly reliable.

In the method described in Patent Document 2, a circuit board is produced by pushing a metal member that is processed into a circuit into an insulation layer that has been softened by heat. In this method, however, voids may be formed at an interface between the metal member and the insulation layer upon pushing, thereby causing a change in dimension due to dislocation of the metal member or a raised resin, and affecting the insulating reliability.

In the method described in Patent Document 3, a highly heat-dissipating substrate is obtained by a method including a process of producing a lead frame, having plural independent patterns and bridges that connects the adjacent patterns, from a metal plate; and combining the same with a highly heat-conductive insulating sheet. In this method, however, it is necessary to punch out the bridges with a punching machine and fill the holes formed by the punching with the insulation layer. Therefore, cracks may by formed around the holes in a case of thick substrate, and formation of voids or irregularity may occur at portions where the holes are filled. As a result, insulation properties may deteriorate due to environmental factors such as humidity. In addition, part of the material that forms bridges, which is to be discarded, contributes to a reduction in use efficiency.

In the method described in Patent Document 4, a circuit board is produced by layering and attaching a sheet of thermosetting resin composition including an inorganic filler and a lead frame having bridges. In this method, the sheet is attached to the lead frame and the bridges are removed together with the sheet by punching, and the holes formed by punching are filled with the resin around the holes by the subsequent pressing process. In this method, however, since a resin including a filler is allowed to flow to fill the holes, the production yield may be affected by inclusion of air bubbles or difference in fluidity between the resin and the filler.

In view of the above, the invention aims to provide a circuit board production method that can produce a circuit board having excellent insulation reliability; a circuit sheet that can produce a circuit board having excellent insulation reliability; and a circuit board having excellent insulation reliability.

### [Means for Solving the Problem]

<1> A circuit board production method, the method comprising a process of disposing a circuit sheet on a substrate, the circuit sheet comprising circuits and a resin portion disposed at spaces between the circuits.
<2> The circuit board production method according to <1>, further comprising, prior to the process of disposing the circuit sheet on the substrate, a process of preparing the circuit sheet comprising circuits and a resin portion disposed at spaces between the circuits, wherein the circuits do not have a bridge.
<3> The circuit board production method according to <1> or <2>, wherein the circuit sheet further comprising a resin portion that is disposed at an outer periphery of the circuits.
<4> The circuit board production method according to any one of <1> to <3>, wherein the resin portion has a linear expansion coefficient of from 10 ppm/K to 50 ppm/K.
<5> The circuit board production method according to any one of <1> to <4>, wherein the circuits have a thickness of 350 µm or more.
<6> The circuit board production method according to any one of <1> to <5>, further comprising a process of disposing an insulation layer between the circuit sheet and the substrate.
<7> The circuit board production method according to <6>, wherein the insulation layer is disposed at at least one of a surface of the circuit sheet that faces the substrate or a surface of the substrate that faces the circuit sheet.
<8> The circuit board production method according to <6> or <7>, wherein the insulation layer is disposed by bonding an insulation layer disposed at a surface of the circuit sheet that faces the substrate with an insulation layer disposed at a surface of the substrate that faces the circuit sheet.
<9> The circuit board production method according to any one of <6> to <8>, wherein the insulation layer is in a partially cured state prior to the process of disposing the circuit sheet on the substrate.
<10> The circuit board production method according to any one of <6> to <9>, wherein the insulation layer has a thickness that is the same as the thickness of the circuits or less than the thickness of the circuits.
<11> A circuit sheet, comprising circuits and a resin portion disposed at spaces between the circuits.
<12> The circuit sheet according to <11>, wherein the circuits do not have a bridge.
<13> The circuit sheet according to <11> or <12>, further comprising a resin portion that is disposed at an outer periphery of the circuits.
<14> The circuit sheet according to any one of <11> to <13>, wherein the resin portion has a linear expansion coefficient of from 10 ppm/K to 50 ppm/K.
<15> The circuit sheet according to any one of <11> to <14>, wherein the circuits have a thickness of 350 µm or more.
<16> The circuit sheet according to any one of <11> to <15>, further comprising an insulation layer that is disposed at at least one surface of the circuit sheet.
<17> The circuit sheet according to <16>, wherein the insulation layer has a thickness that is less than a thickness of the circuits.
<18> A circuit board, comprising a substrate and circuits that are disposed on the substrate and that are formed from the circuit sheet according to any one of <11> to <17>.

### [Effect of the Invention]

According to the invention, a circuit board production method that can produce a circuit board having excellent insulation reliability; a circuit sheet that can produce a circuit board having excellent insulation reliability; and a circuit board having excellent insulation reliability are provided.

### [Brief Description of the Invention]

Fig. 1 is a perspective view conceptually showing an example of a circuit sheet.
Fig. 2 is a sectional view conceptually showing an example of a circuit sheet.
Fig. 3 is a perspective view conceptually showing an example of a circuit sheet having an insulation layer.
Fig. 4 is a sectional view conceptually showing an example of a circuit sheet having an insulation layer.
Fig. 5 is a perspective view conceptually showing an example of a circuit board.
Fig. 6 is a sectional view conceptually showing an example of a circuit board.
Fig. 7 is a sectional view conceptually showing a state of a circuit board prepared in the Examples.
Fig. 8 is a sectional view conceptually showing a state of a circuit board prepared in the Comparative Examples.
Fig. 9 is a sectional view conceptually showing a state of a circuit board prepared by conventional arts described in Patent Documents 3 and 4, prior to removing bridges that connect the circuits.
Fig. 10 is a sectional view conceptually showing a state of a circuit board prepared by conventional arts described in Patent Documents 3 and 4, after removing the bridges by punching.

### [Description of Embodiments]

Hereinafter, embodiments for carrying out the invention will be described in detail. However, the invention is not limited to the following embodiments. In the following embodiments, components (including element steps and the like) are not essential unless otherwise specified. The same applies to numerical values and ranges thereof, and the invention is not limited thereto.

In the disclosure, the "process" refers not only to a process that is independent from the other steps, but also to a step that cannot be clearly distinguished from the other steps, as long as the aim of the process is achieved.

In the disclosure, the numerical range represented by "from A to B" includes A and B as a minimum value and a maximum value, respectively.

In the disclosure, when numerical ranges are described in a stepwise manner, the values of the upper or lower limit of each numerical range may be substituted by the values of the upper or lower limit of the other numerical range, or may be substituted by the values described in the Examples.

In the disclosure, when there are more than one kind of substances corresponding to a component of a composition, the content of the component refers to a total content of the substances, unless otherwise stated.

In the disclosure, a "layer" or a "film" may be formed over an entire region or may be formed over part of a region, upon observation of the region.

In the disclosure, the term "layered" refers to a state in which a layer is positioned on another layer, and the layers may be bounded to each other, or may be detachable.

In the disclosure, when an embodiment is described with reference to the drawings, the configuration of the embodiment is not limited to that shown in the drawings. The size of the members in the drawings are conceptual, and the relative relationship in size between the members is not limited thereto.

### <Circuit Board Production Method>

The circuit board production method according to the embodiment includes a process of disposing a circuit sheet on a substrate, and the circuit sheet includes a resin portion disposed at spaces between the circuits.

In the method of the embodiment, a circuit sheet having a resin portion disposed at spaces between the circuits is used. Therefore, it is possible to dispose the circuit on a substrate in an easy and accurate manner.

Furthermore, in the method of the embodiment, it takes less time to form a circuit and it is easier to control a cross-sectional shape of the circuit, as compared with a case of forming a circuit by etching copper. Therefore, the thickness of the circuit can be easily increased. Accordingly, the cross-sectional area of the circuit can be increased without increasing the width of the same, thereby achieving an increase in the amount of current while satisfying a demand for downsizing of a circuit board. Further, by increasing the thickness of a circuit, it is also possible to promote the diffusion of heat in a surface direction, and suppressing an increase in temperature rise of a circuit board.

Further, in the method of the embodiment, a circuit board having excellent insulation reliability can be manufactured by using a circuit sheet that includes a resin portion disposed at spaces between the circuits. The reason for this is not necessarily clear, but is presumed as follows.

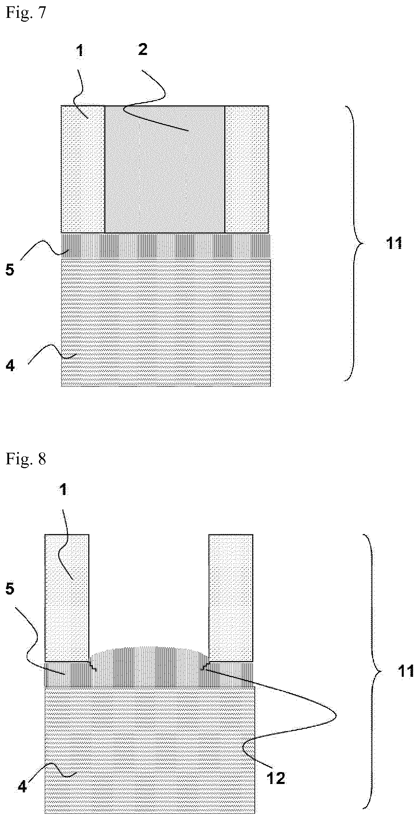

In a method in which pressure is applied to a circuit, not having a resin portion at spaces between circuits, being disposed on an insulation layer provided on a substrate, as shown in Fig. 8, a portion of insulation layer 5 that is not in contact with circuits 1 is raised due to pressure and becomes a cause for cracks or the like. In contrast, when a circuit sheet, having a resin portion at spaces between circuits, is disposed on an insulation layer provided on a substrate and pressure is applied, as shown in Fig. 7, it is considered that raising of insulation layer 5 between circuits 1 is suppressed by resin portion 2, and occurrence of cracks or the like is also suppressed.

The circuit board production method preferably further includes, before the process of disposing the circuit sheet on the substrate, a process of preparing a circuit sheet, wherein the circuit sheet includes circuits and a resin portion disposed at spaces between the circuits, but does not have a bridge.

In this method, since a circuit sheet having a resin portion disposed at spaces between the circuits is used, the resin portion has a function of connecting the circuits, without a bridge. As a result, it is possible to effectively prevent occurrence of misalignment when a circuit is disposed on a circuit, thereby improving the alignment accuracy. In addition, by using a circuit sheet having the above-described configuration, it is possible to omit a process of insulating the circuits after disposing the same on a substrate, and an effect of improving the production efficiency of a circuit board can be expected. Further, since a bridge is not provided for preventing misalignment of the circuit, there is no need to consider a damage to a resin disposed between the circuits or an insulation layer due to removal of the bridge.

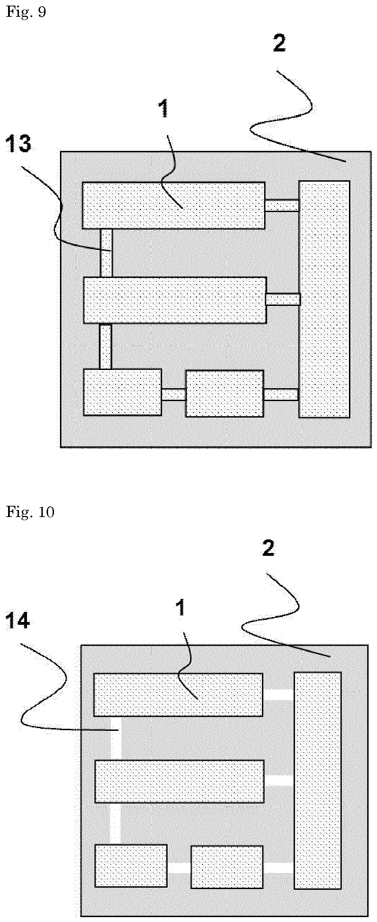

Furthermore, as shown in Fig. 9, when there is bridge 13 that connects circuits 1, spaces 14 may exist after the removal of bridge 13 as shown in Fig. 10, and sufficient insulation reliability may not be obtained.

In the method as mentioned above, a state in which a circuit sheet is "disposed" on a substrate refers to either a state in which a circuit sheet is not embedded at all in a member that is in contact with the circuit sheet (i.e., the embedding depth is 0 µm), or a state in which a circuit sheet is embedded to a member at a depth of within 20 µm.

The method of disposing a circuit sheet on a substrate is not particularly limited. For example, the method may be performed such that the circuit sheet is positioned over the substrate in a direction of gravity, or that the substrate is positioned over the circuit sheet in a direction of gravity. It is also possible to perform the process by other methods.

The thickness of a circuit is not particularly limited, and can be selected depending on the purpose or the like of a circuit board to be produced. From the viewpoint of increasing the amount of current of a circuit board, the thickness of a circuit is preferably 350 µm or more, more preferably 500 µm or more, and still more preferably 1,000 µm or more. From the viewpoint of the volume and the weight, the thickness of a circuit may be, for example, 3,000 µm or less.

When the value differs depending on the locations, the arithmetic average value of the measured values obtained at arbitrarily selected five locations may be used as the above value.

The thickness of the above circuit means the thickness of the circuit itself, and when a part of the circuit is embedded in an adjacent member, the thickness of the embedded portion is included in the thickness of the circuit.

The width and the length of a circuit are not particularly limited, and may be selected depending on the purpose or the like of a circuit board to be produced. For example, the width and the length can be selected from the range of from 350 µm to 70,000 µm. When the value differs depending on the locations, the arithmetic average value of the measured values obtained at arbitrarily selected five locations may be used as the above value.

A circuit may be obtained, for example, by processing a metal plate into a circuit of a desired shape. The method for processing is not particularly limited, and may be selected from known methods, such as punching or cutting.

The material of a circuit is not particularly limited. Examples thereof include a metal such as copper, silver, chromium copper, tungsten copper, nickel, nickel-plated copper, aluminum, or aluminum whose surface is modified to anodized. From the viewpoint of conductivity, the circuit preferably includes copper.

The resin used for a resin portion is not particularly limited. Examples thereof include a thermosetting resin such as an epoxy resin, a phenol resin, a urea resin, a melamine resin, a urethane resin, a silicone resin, an unsaturated polyester resin, an acrylic resin, an imide resin, or an amideimide resin. The resin used for a resin portion may be one kind or two or more kinds. From the viewpoint of electrical insulation and adhesiveness, the resin used for a resin portion preferably include at least one selected from the group consisting of an epoxy resin, a silicone resin, an amideimide resin, and a urethane resin, and from the viewpoint of moisture resistance, it is preferable to include at least one selected from the group consisting of an epoxy resin, an acrylic resin, and an amideimide resin. The resin used for a resin portion may include a component other than resin, such as a filler (powder, fiber, or the like) if necessary.

The method of providing a resin portion at spaces between circuits is not particularly limited. Examples of the method using a solid resin material, such as a powder, include an extrusion molding method, a compression molding method, a transfer molding method, and an insert molding method. Examples of the method using a liquid resin material include a casting method, a coating method, a printing method, and an embedding method. In a process of disposing a resin portion at spaces between circuits, a circuit sheet may be placed on a temporary base material, such as a resin sheet.

The state that a resin portion is "disposed at spaces between circuits " refers to a state in which a resin portion is provided at least at a portion at which expression of an effect by providing the resin portion is required, and it is not necessary that the resin portion is disposed at all spaces between the circuits. For example, the state includes a case in which a resin portion is not disposed at a portion that does not contribute to an effect achieved by the method of the embodiment. The state also includes a case in which a space that is unintentionally created upon formation of a resin portion, such as voids, cracks or unfilled parts, as long as the space is not practically problematic.

In a circuit sheet, the ratio of a resin portion disposed at spaces between circuits may differ depending on the factors such as the shape of the circuit, the material of a substrate (or an insulation layer), or the production conditions of a circuit board. For example, a resin portion may be disposed at all spaces between the circuits. For example, when a circuit sheet is viewed from the above (plan view), a resin portion may be present at all of the regions corresponding to a space between the circuits. The term "all" in these cases does not consider a portion that does not contribute to an effect achieved by the method of the embodiment, for example, a space without resin that is unintentionally generated upon formation of a resin portion.

The thickness of a resin portion in a circuit sheet is preferably from 80% to 120%, more preferably from 90% to 110%, and still more preferably from 95% to 105%, with respect to the thickness of a circuit. When the value differs depending on the locations, the arithmetic average value of the measured values obtained at arbitrarily selected five locations may be used as the above value.

From the viewpoint of maintaining insulation properties, the linear expansion coefficient of a resin portion is preferably from 10 ppm/K to 50 ppm/K, and more preferably from 12 ppm/K to 45 ppm/K.

The linear expansion coefficient of a resin portion is expressed as a slope of a tangent line obtained in a case in which the strain of a sample is plotted against the temperature by a thermomechanical analysis method, and is a value measured at a temperature region that is equal to or lower than the glass transition temperature of the sample.

Since a circuit used in a circuit sheet does not have a bridge, it is not necessary to remove the same by a method such as punching, cutting or etching, when using the circuit for a circuit sheet or a substrate. Therefore, it is less likely to generate cracks at a periphery of a portion from which a bridge has been removed, or to cause deterioration in insulation at a portion that has been filled after removal of a bridge due to voids, unevenness or the like, as well as humidity. It is also possible to reduce the amount of a material to be used for forming a bridge.

From the viewpoint of handling a circuit sheet, as a single sheet, the circuit and the resin portion are preferably in an integrated state. For example, the circuit sheet preferably has a resin portion disposed at the outer periphery of the circuits. In that case, it is more preferable that at least a part of the resin portion, disposed at spaces between circuits, and at least a part of a resin portion, disposed at the outer periphery of the circuits, are connected to each other.

When a circuit and a resin portion are in an integrated state, it is less likely to cause unevenness in pressure during press molding or dislocation during the production of a circuit board, and insulation reliability thereof tends to be improved. In addition, contact with moisture of a circuit is suppressed and moisture-resistance reliability of a circuit board is sufficiently secured, whereby occurrence of creeping discharge, partial discharge, tracking, migration, or the like tends to be suppressed.

A circuit sheet may have a roughened surface. For example, when a surface of a circuit sheet that faces an insulation layer is roughened, sufficient adhesion between the circuit sheet and the insulation layer can be attained while suppressing generation of voids. Specifically, it is considered that roughening of a surface of a circuit sheet to be in contact with an insulation layer improves the adhesion by van der Waals force, by improving the pulling force by an anchor effect or increasing the contact area. The roughening treatment of a circuit sheet may be performed to either one of a circuit and a resin portion or both of them. When a roughening treatment is performed on either one or both of a circuit and a resin portion, it is preferable to perform the roughening treatment at least for the one with less adhesive strength with respect to an insulation layer.

The method of roughening a circuit sheet is not particularly limited, and the treatment may be performed by a physical method or a chemical method. For example, when the material of a circuit is copper, examples of the physical method include file processing, sandblasting, laser irradiation, and milling. Examples of the chemical method include a MacDermid treatment, a CZ treatment, a blackening treatment, and an etching treatment. The roughening treatment may be performed by any one of the above methods or combination of two or more kinds. When two or more kinds are combined, a physical method and a chemical method may be combined, chemical methods may be combined with each other, or physical methods may be combined with each other. Examples of the method of roughening a resin portion include a desmear treatment and a chemical deflash, and any one of these methods may be used alone or in combination.

The roughening treatment of a circuit sheet may be performed in a state in which a resin portion is not present or in a state in which a resin portion is present. An advantage of performing a roughening treatment on a circuit sheet in the absence of a resin portion is, for example, that not only the adhesion of a circuit with respect to an insulation layer but also the adhesion with respect to a resin portion is improved. An advantage of performing a roughening treatment on a circuit sheet in a state in which a resin portion is present is, for example, that a roughening treatment on a circuit and a roughening treatment on a resin portion can be performed collectively.

The production method of a circuit sheet is not particularly limited. For example, a circuit sheet can be produced by a method as follows. First, a circuit is obtained by cutting a metal plate into a desired shape by punching, machining or the like, and then deburring the same. Next, the circuit is disposed on a temporary base material such as an adhesive film. It is possible to removal of burrs, residues or the like generated during circuit formation, if necessary. Subsequently, a resin portion is formed at spaces between circuits, and optionally at an outer peripheral portion of the circuits, and a curing treatment or the like is performed if necessary. The temporary base material is then peeled from a circuit. Thereafter, if necessary, removal of burrs generated during formation of a resin portion, a post-curing treatment of a resin, and the like are performed, whereby a circuit sheet is obtained.

The kind of a substrate used for producing a circuit board is not particularly restricted. For example, a member having a heat-dissipation function, such as a heat spreader, may be used. Examples of the heat spreader include a member such as a fin, a case having a flow path for air or water, or a metal plate that is attached via a grease. The material of a substrate is not particularly limited, and examples thereof include a copper alloy such as copper, aluminum, tungsten copper, or molybdenum copper, and nickel-plated copper. The surface of a substrate may be smooth or roughened. The roughening treatment method may be selected from those exemplified as the roughening treatment method for a circuit sheet.

A circuit board preferably has an insulation layer that is disposed between a circuit sheet and a substrate.

The material of an insulation layer is not particularly limited. Examples thereof include a resin such as an epoxy resin, a phenol resin, a urea resin, a melamine resin, a urethane resin, a silicone resin, an unsaturated polyester resin, and an acrylic resin. From the viewpoint of heat resistance, a thermosetting resin is preferable. A resin contained in an insulation layer may be one kind or two or more kinds. From the viewpoint of insulation and adhesion with respect to a circuit sheet, the insulation layer preferably includes an epoxy resin. The insulation layer may include a component other than a resin such as a filler (powder, fiber, or the like) if necessary.

From the viewpoint of a balance in the properties required for an insulation layer, an epoxy resin is preferable among the above resins, and an epoxy resin having a mesogenic group is more preferable. Examples of the mesogenic structure include a biphenyl structure, a phenylbenzoate structure, a cyclohexylbenzoate structure, an azobenzene structure, a stilbene structure, a terphenyl structure, an anthracene structure, a derivative thereof, and a structure in which two or more of these mesogenic structures are bonded via a bonding group.

An epoxy resin having a mesogenic group may include an epoxy compound having one or more structures represented by the following Formula (I).

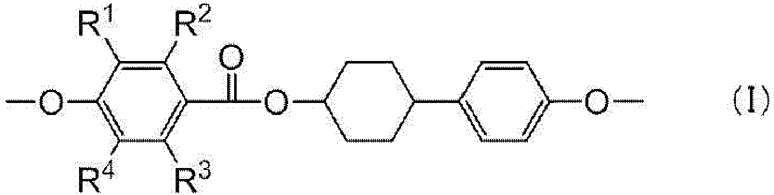

In Formula (I), each of R¹ to R⁴ independently represents a hydrogen atom or an alkyl group having from 1 to 3 carbon atoms. Each of R¹ to R⁴ is independently preferably a hydrogen atom or an alkyl group having from 1 to 2 carbon atoms, more preferably a hydrogen atom or a methyl group, and still more preferably a hydrogen atom. Two to four of R¹ to R⁴ are preferably hydrogen atoms, more preferably three or four are hydrogen atoms, and still more preferably all four are hydrogen atoms. When any of R¹ to R⁴ is an alkyl group having from 1 to 3 carbon atoms, at least one of R¹ and R⁴ is preferably an alkyl group having from 1 to 3 carbon atoms.

Examples of the epoxy compound having a structure represented by Formula (I) include an epoxy compound represented by the following Formula (M).

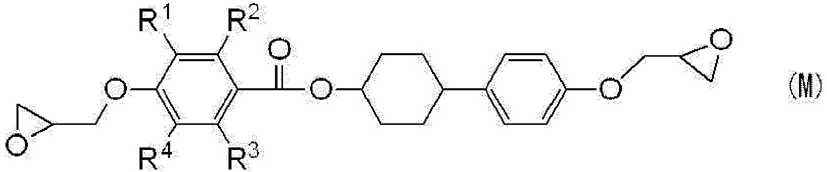

Specific examples of R¹ to R⁴ in Formula (M) are the same as the specific examples of R¹ to R⁴ in Formula (I), and preferred ranges thereof are also the same.

An epoxy resin may be combined with a curing agent. As the curing agent, a phenol curing agent, such as a phenol novolac resin, is preferable.

The thickness of an insulation layer is not particularly limited, and can be selected according to the purpose or the like of a circuit board. From the viewpoint of ensuring sufficient insulation, the thickness of an insulation layer is preferably as thick as possible. For example, the thickness is preferably 70 µm or more, more preferably 90 µm or more, and still more preferably 110 µm or more.

From the viewpoint of ensuring sufficient heat dissipation, the thickness of the insulation is preferably as small as possible. For example, the thickness is preferably 230 µm or less, more preferably 210 µm or less, and still more preferably 190 µm or less. The thickness of an insulation layer is preferably smaller than the thickness of a circuit used in the circuit sheet. As will be described below, when an insulation layer is disposed on both of a surface of a circuit sheet that faces a substrate and a surface of a substrate that faces a circuit sheet, the thickness of the insulation layer refers to the total thickness of the insulation layers.

The method of disposing an insulation layer between a circuit sheet and a substrate is not particularly limited. Examples of the method include a method of attaching a sheet-like insulation layer to a surface of at least one of a circuit sheet and a substrate, and performing a curing treatment or the like if necessary; and a method of applying a resin composition for forming an insulation layer to a surface of at least one of a circuit sheet and a substrate, and performing a curing treatment or the like if necessary. From the viewpoint of processing efficiency, it is preferable to dispose an insulation layer on one or both of a surface of the circuit sheet that faces the substrate and a surface of the substrate that faces the circuit sheet.

From the viewpoint of increasing the adhesion with respect to a circuit sheet and a substrate, and further improving the insulation reliability, an insulation layer is preferably disposed on each of a surface of the circuit sheet that faces the substrate and a surface of the substrate that faces the circuit sheet, respectively, and the insulation layers are bonded to each other.

When an insulation layer is disposed on each of a surface of the circuit sheet that faces the substrate and a surface of the substrate that faces the circuit sheet, respectively, the material or the thickness of the insulation layers may be the same or different from each other. The material or the thickness of each insulation layer can be determined depending on a state of a circuit sheet or a substrate (adhesion with respect to an insulation layer, degree of unevenness in thickness, or the like)

From the viewpoint of obtaining sufficient insulation, an insulation layer is preferably disposed by using a resin composition. The method of disposing an insulation layer using a resin composition is not particularly limited. For example, the method can be performed by applying a resin composition to a surface of at least one of a circuit sheet and a substrate with a dispensing method, a spray method, a gravure method, screen printing, screen printing using a metal mask, transferring, or the like.

When an insulation layer is disposed using a resin composition, it is preferable to use a resin composition in a liquid state. By using a liquid resin composition, even when a circuit sheet has an irregular surface due to uneven thickness of a circuit and a resin portion, or the like, generation of voids or the like tends to be suppressed and an insulation layer having excellent insulating properties tends to be obtained. In addition, even when a substrate has a surface that is not flat due to waviness, unevenness or the like, an insulation layer having excellent insulating properties tends to be obtained by using a liquid resin composition.

In the disclosure, a resin composition that is "liquid" refers to a resin composition that is in a state of a liquid at least at a time of applying the same to a circuit sheet or a substrate. The degree of being liquid is not particularly limited, and can be selected according to a state of a surface of a circuit sheet or a substrate, a method of applying a resin composition, and the like. For example, the viscosity of a resin composition when applying the same to a member is preferably 10 Pa·s or less. The viscosity of a resin composition is a value measured at 5 rotations/minute (rpm) using an E-type viscometer (Toki Sangyo Co., Ltd., TV-33) at a temperature at which the resin composition is applied to a member (for example, a temperature in a range of from 18 °C to 23 °C).

When an insulation layer is disposed using a liquid resin composition, the resin composition may include a component for adjusting the viscosity, such as a solvent. When a resin composition includes a solvent, the solvent may be removed by drying or the like after the application of the resin composition onto a circuit sheet or a substrate. The content of a solvent remaining in a resin composition, after removal of the same, is preferably 2% by mass or less, more preferably 1% by mass or less, with respect to the total resin composition.

From the viewpoint of processing efficiency of a circuit board production method, an insulation layer is preferably formed from a semi-cured insulation layer. Specifically, an insulation layer is preferably in a semi-cured (B stage) state prior to a process of disposing a circuit sheet on a substrate. The method and the conditions of making an insulation layer in a semi-cured state are not particularly limited, and can be set according to the composition of a resin composition. When an insulation layer is in a semi-cured state before a process of disposing a circuit sheet on a substrate, it is preferable to cure the insulation layer by performing a post-curing treatment after disposing the circuit sheet on the substrate. The method and the conditions for a post-curing treatment are not particularly limited, and can be set according to the composition of a resin composition.

From the viewpoint of increasing the adhesion of an insulation layer with respect to a circuit sheet or a substrate, the viscosity of the insulation layer before curing is preferably from 10⁴ Pa·s to 10⁹ Pa·s at room temperature (25 °C) and from 10² Pa·s to 10⁷ Pa·s at 100 °C, and the viscosity preferably decreases by a degree of from 0.0001% to 50% when a temperature changes from room temperature (25 °C) to 100 °C. It is preferable that an insulation layer after curing does not melt by heating. The viscosity is a value that can be measured by dynamic viscoelasticity measurement (frequency: 1 Hz, load: 40 g, temperature increase rate: 3 °C/min).

From the viewpoint of improving the adhesion between a circuit sheet and a substrate (or insulation layer), it is preferable to perform at least one of heating or pressurization when disposing the circuit sheet on the substrate, more preferably performing both heating and pressurization. The heating temperature is not particularly limited, and can be selected from the range of from 50 °C to 250 °C, for example. The pressure for the pressurization is not particularly limited, and can be selected from the range of from 0.1 MPa to 50 MPa, for example.

The method of pressurizing a circuit sheet is not particularly limited. In order to average the pressure distribution, it is preferable to apply a pressure while disposing a cushioning member (paper, board, cloth, or the like) on a circuit sheet. The pressurization is preferably performed so as to reduce a difference in thickness of the resin portion and the circuits. The pressurization may be performed from the substrate-side while fixing the circuit sheet or from the circuit sheet-side while fixing the substrate, or may be performed without fixing either the substrate or the circuit sheet.

The method of heating a circuit sheet is not particularly limited. Example thereof include a method of setting the temperature of a member used for the pressurization to a desired temperature. From the viewpoint of obtaining a circuit board with a smooth surface and a thickness with reduced unevenness, a method of heating while applying a pressure to a laminate, in which a circuit sheet, an insulation layer that is disposed if necessary, and a substrate are layered in this order, by sandwiching the same between a pair of hot plates is preferred.

A circuit board that is produced by the above method exhibits excellent insulation reliability. Further, since the thickness of a circuit can be increased, the circuit board is suitable for applications in which the amount of current needs to be increased.

### <Circuit Sheet>

The circuit sheet of the embodiment includes a circuit and a resin portion disposed at spaces between circuits.

The details and preferred embodiments of the circuit sheet are the same as the details and preferred embodiments of the circuit sheet used in the circuit board production method of the above-described embodiment.

The circuit sheet may further include an insulation layer that is disposed at at least one surface thereof. The details of the insulation layer are the same as the details of the insulation layer used in the circuit board production method of the embodiment described above.

The method of disposing an insulation layer at at least one surface of the circuit sheet is not particularly limited. Examples of the method include a method of attaching a sheet-like insulation layer to at least one surface of a circuit sheet, and optionally performing a curing treatment or the like; and a method of applying a resin composition for forming an insulation layer to at least one surface of a circuit sheet, and optionally performing a curing treatment or the like.

### <Circuit Board>

The circuit board of the embodiment includes a substrate and a circuit formed from a circuit sheet of the above-described embodiment that is disposed on the substrate.

The details and preferred embodiments of the circuit board of the embodiment are the same as the details and preferred embodiments of the circuit board produced by the circuit board production method of the above-described embodiment.

Hereinafter, specific embodiments of a circuit board production method, a circuit sheet, and a circuit board will be described with reference to the drawings, but the invention is not limited to these embodiments. The size of members in each figure is conceptual, and the relative relationship of the size thereof is not limited thereto.

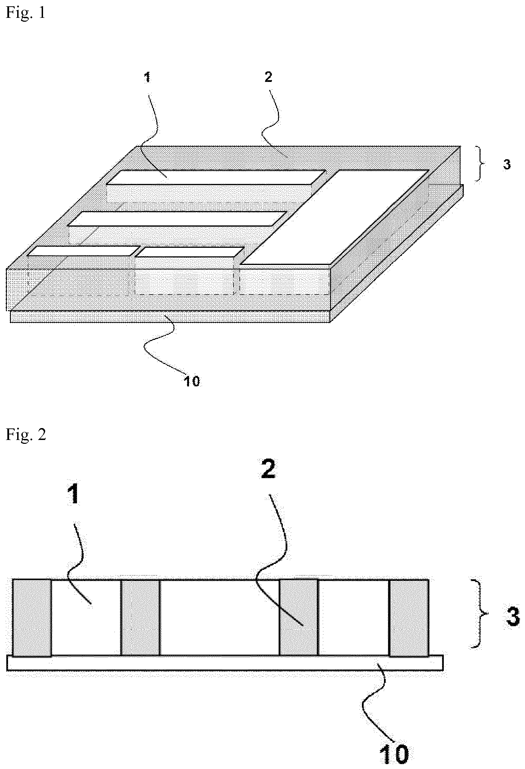

Fig. 1 is a perspective view conceptually showing an example of a circuit sheet used in a circuit board production method, and Fig. 2 is a sectional view conceptually showing an example of a circuit sheet used in a circuit board production method. As shown in Figs. 1 and 2, circuit sheet 3 includes circuits 1 and resin 2 disposed at spaces between circuits 1. In Figs 1 and 2, circuit sheet 3 is disposed on temporary base material 10.

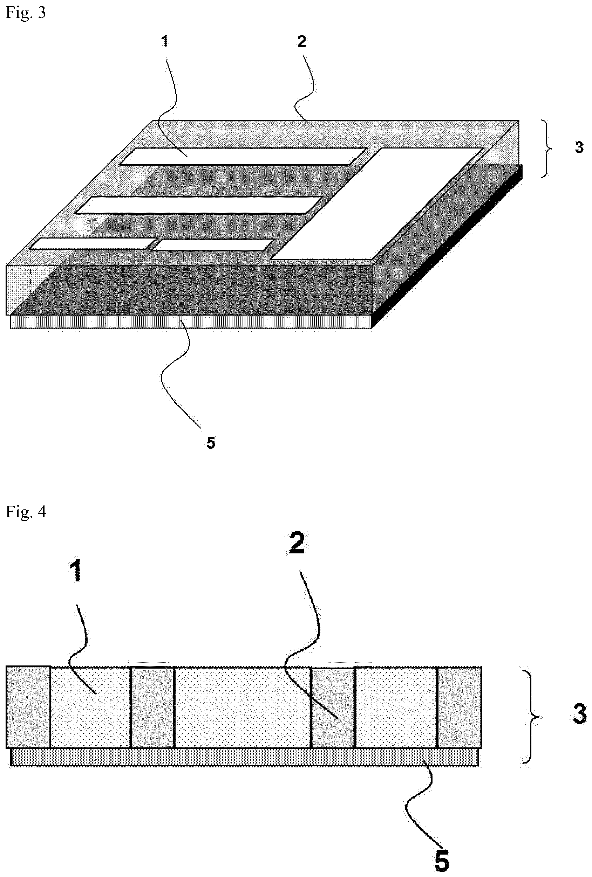

Fig. 3 is a perspective view conceptually showing an example of a circuit sheet provided with an insulation layer, and Fig. 4 is a sectional view conceptually showing an example of a circuit sheet provided with an insulation layer. In Figs. 3 and 4, circuit sheet 3 has insulation layer 5 disposed on a surface thereof from which temporary base material 10 has been removed.

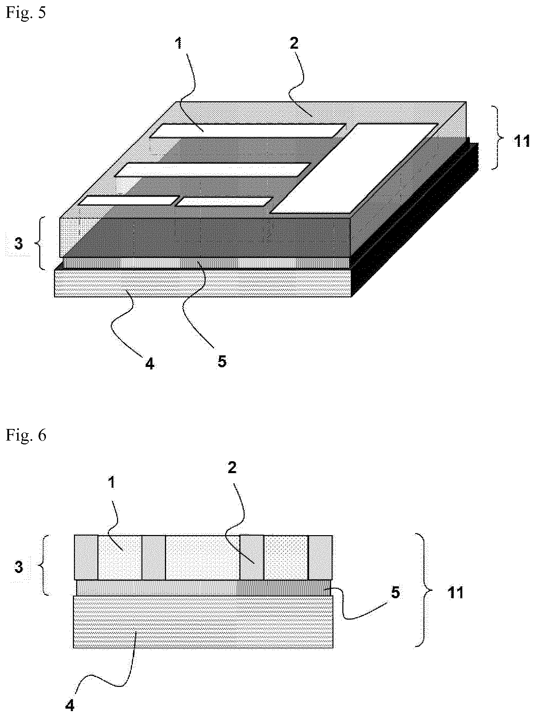

Fig. 5 is a perspective view conceptually showing an example of a circuit board produced by a circuit board production method, and Fig. 6 is a sectional view conceptually showing an example of a circuit board produced by a circuit board production method. In Figs. 5 and 6, circuit board 11 is in a state of a laminate in which circuit sheet 3, insulation layer 5, and substrate (heat spreader) 4 are disposed in this order.

### [Examples]

Hereinafter, the embodiments as described above will be specifically described by referring to the Examples, but the embodiments are not limited to the Examples.

Formation of an insulation layer in the Examples and Comparative Examples was performed using an epoxy resin composition. Materials used for the preparation of an epoxy resin composition and abbreviations thereof are shown below.

### (Epoxy monomer A having mesogenic structure (Monomer A))

### [4-{4-(2,3-epoxypropoxy)phenyl}cyclohexyl=4-(2,3-epoxypropoxy)benzoate, epoxy equivalent: 212 g/eq, produced by the method described in JP-ANo. 2011-74366]

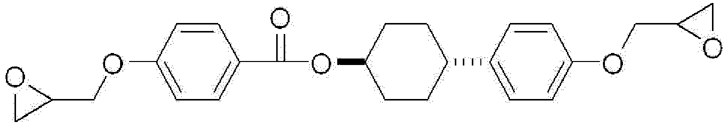

### (Epoxy monomer B having mesogenic strucrure (Monomer B))

YL6121H [biphenyl-type epoxy monomer, manufactured by Mitsubishi Chemical Corporation, epoxy equivalent: 172 g/eq]

### (Inorganic Filler)

AA-3 [alumina particles, manufactured by Sumitomo Chemical Co., Ltd., volume average particle size (D50): 3 µm]
AA-04 [alumina particles, manufactured by Sumitomo Chemical Co., Ltd., volume average particle size (D50): 0.40 µm]
HP-40[boron nitride particles, manufactured by Mizushima Ferroalloy Co., Ltd., volume average particle size (D50): 40 µm]

### (Curing Agent)

CRN [catechol resorcinol novolac resin (charging ratio based on mass: catechol/resorcinol = 5/95) synthesized by the following method, containing 50% by mass of cyclohexanone]

### <Method of synthesizing curing agent (CRN)>

A 3L-separable flask with a stirrer, a cooler, and a thermometer was charged with 627 g of resorcinol, 33 g of catechol, 316.2 g of aqueous formaldehyde solution (37% by mass), 15 g of oxalic acid, and 300 g of water. The temperature was raised to 100 °C while heating in an oil bath. The mixture was refluxed at around 104 °C, and the reaction was continued at the reflux temperature for 4 hours. The temperature in the flask was then raised to 170 °C while distilling off water. The reaction was continued for 8 hours while maintaining the temperature at 170 °C. After the reaction, concentration was performed under reduced pressure for 20 minutes, removing water or the like in a system, thereby obtaining a phenol novolac resin (CRN).

Measurement of Mn (number average molecular weight) and Mw (weight average molecular weight) of the obtained CRN was performed using a high-performance liquid chromatography (manufactured by Hitachi, Ltd., trade name: L6000) and a data analyzer (manufactured by Shimadzu Corporation, trade name: C-R4A). GPC columns (G2000HXL and G3000HXL (trade name) manufactured by TOSOH CORPORATION) were used for the analysis. The sample concentration was 0.2% by mass, tetrahydrofuran was used as a mobile phase, and measurement was performed at a flow rate of 1.0 mL/min. A calibration curve was prepared using a polystyrene standard sample, and Mn and Mw were calculated as polystyrene values using the standard curve. As a result, Mn was 422 and Mw was 564.

With respect to the obtained CRN, the hydroxyl equivalent was measured by acetyl chloride-potassium hydroxide titration method. Determination of the titration end point was carried out by potentiometric titration rather than coloration with an indicator because the solution color was dark. Specifically, after hydroxy groups of a resin for the measurement were acetylated in a pyridine solution, excess reagent was decomposed with water, and the resulting acetic acid was titrated with a potassium hydroxide/methanol solution. The result was 62 g/eq.

### (Curing Accelerator)

TPP: Triphenylphosphine [manufactured by Wako Pure Chemical Industries, Ltd., product name]

### (Additive)

KBM-573: 3-phenylaminopropyltrimethoxysilane [silane coupling agent, manufactured by Shin-Etsu Chemical Co., Ltd., trade name]

### (Solvent)

CHN: Cyclohexanone

### (Preparation of epoxy resin composition)

An epoxy monomer mixture was obtained by mixing epoxy monomers having a mesogenic structure, monomer A and monomer B, at an epoxy equivalent (monomer A: monomer B) of 8:2. 8.19% by mass of this epoxy monomer mixture was mixed with 4.80% by mass of CRN as a curing agent, 0.09% by mass of TPP as a curing accelerator, 39.95% by mass of HP-40, 9.03% by mass of AA-3 and 9.03% by mass of AA-04 as inorganic fillers, 0.06% by mass of KBM-573 as an additive, and 28.85% by mass of CHN as a solvent, thereby preparing a varnish-like epoxy resin composition.

The ratio by volume of the inorganic filler with respect to the total solid content of the epoxy resin composition was calculated, by assuming the density of boron nitride (HP-40) as 2.20 g/cm³, the density of alumina (AA-3 and AA-04) as 3.98 g/cm³, and the density of a mixture of the epoxy monomers (monomer A and monomer B) and the curing agent (CRN) as 1.20 g/cm³. The result was 72% by volume.

### <Example 1>

A circuit was formed from a copper plate having a thickness of 500 µm by punching cutting, and was fixed on an adhesive film for preventing misalignment. Next, the circuit was fixed to a mold, and spaces between the circuits were filled an epoxy resin (Hitachi Chemical Co., Ltd., model number: CEL-4650M, linear expansion coefficient: 14 ppm/°C), and a press treatment was performed with a transfer press machine (Techno Marushichi Co., Ltd., general-purpose press machine) under predetermined conditions (temperature: 175°C, pressure: 8 MPa, time: 3 minutes), thereby forming and a resin portion. Next, the circuit was removed from the mold, the adhesive film was peeled off and burrs were removed by cutting, and a circuit sheet was obtained by performing a post-curing treatment at an oven temperature of 180 °C for 6 hours. The thickness of the resin portion in the circuit sheet was the same as the thickness of the circuit.

The circuit sheet was fixed to a stage of a dispenser (Musashi Engineering, Inc., model number: HPC-3), and an epoxy resin composition prepared by the method described above was applied thereon in such a manner that the thickness was 90 µm so as to cover the entire circuit sheet, dried in an explosion-proof oven at 130 °C for 7.5 minutes, and a semi-cured insulation layer was formed. Meanwhile, a flat copper plate (thickness: 0.5 mm) to be used as a heat spreader is fixed to the stage of the dispenser, and a liquid resin composition for forming an insulation layer was applied, to the same size as that applied to the circuit sheet, dried in an explosion-proof oven at 130°C for 7.5 minutes, and a semi-cured insulation layer was formed.

Next, the circuit sheet and the heat spreader were disposed in such a manner that an insulation layer formed on the circuit sheet side and an insulation layer formed on the heat spreader side were opposed to each other, and the insulation layers were bonded to each other by vacuum thermocompression to obtain a circuit board. Specifically, the pressing temperature was raised to 180 °C from 50 °C at a rate of 3 °C/min and maintained at 180 °C for 2 hours, then cooled down to 50 °C while applying pressure. The process was performed at a degree of vacuum of 1 kPa or less and a press pressure of 10 MPa, from the start of the temperature rise to the completion of the cooling.

### <Example 2>

A circuit board was produced in the same manner as Example 1, except that a circuit sheet was produced using a copper plate with a thickness of 1,000 µm instead of a copper plate with a thickness of 500 µm (the thickness of a resin portion is the same as the thickness of a circuit) and that a copper plate with a thickness of 1,000 µm was used instead of a copper plate with a thickness of 500 µm as the heat spreader.

### <Example 3>

A circuit board was produced in the same manner as Example 1, except that a circuit sheet was produced using a copper plate with a thickness of 2,000 µm instead of a copper plate with a thickness of 500 µm (the thickness of a resin portion is the same as the thickness of a circuit) and that a copper plate with a thickness of 2,000 µm was used instead of a copper plate with a thickness of 500 µm as the heat spreader.

### <Comparative Example 1>

A circuit board was prepared in the same manner as Example 1, except that a circuit sheet in which a resin portion was not formed at spaces between circuits was used instead of the circuit sheet.

### <Comparative Example 2>

A circuit board was prepared in the same manner as Example 2, except that a circuit sheet in which a resin portion was not formed at spaces between circuits was used instead of the circuit sheet.

### <Comparative Example 3>

A circuit board was prepared in the same manner as Example 3, except that a circuit sheet in which a resin portion was not formed at spaces between circuits was used instead of the circuit sheet.

### (Measurement of Breakdown Voltage)

A surface of the circuit board at the circuit was formed and a surface of the heat spreader opposite to the circuit side were connected to a power source, respectively. The entire circuit board was placed in a coolant (Fluorinert, trade name) and the dielectric breakdown voltage was measured. The measurement was performed by repeating a step of increasing a voltage, from 500 (V) by 500 (V) and holding for 30 seconds, and the voltage at which the current value exceeded 0.2 (mA) was defined as the dielectric breakdown voltage (kV). The results are shown in Table 1.

### (Measurement of Misalignment)

Whether or not the circuits of the circuit boards produced in the Examples and the Comparative Examples were disposed at predetermined positions was evaluated using a three-dimensional measuring machine (Keyence Corporation, model: VR-3000D). Specifically, in order to prevent misalignment of a circuit board to be measured, frames were set at four corners on a stage, and the circuit board was fixed thereto. As a reference, the data of a pattern of the circuit board that were close to the design drawing were obtained. The amount of misalignment (µm) was obtained by comparing the center position of the circuit of the circuit board and the center position of the circuit of the reference.

### (Method of Measuring Linear Expansion Coefficient)

The linear expansion coefficient of a resin portion of a circuit sheet was evaluated using a thermomechanical analyzer (manufactured by SII, model number: EXSTAR6000). Specifically, a sample (30 mm × 3 mm and 0.2 mm in thickness) was prepared from a cured product obtained by curing an epoxy resin used for forming the resin portion, and the temperature dependence of the elongation of the sample at the tensile measurement was measured. The measurement was performed under the following conditions. The condition for removing distortion of a sample was from 25°C to 150°C, the scan temperature was from 25°C to 300°C, the slope of tangent when plotting, in the graph plotting strain against temperature from 25°C to 150°C, which is a temperature not higher than the glass transition temperature of the sample, was assumed as the coefficient of linear expansion. The heating rate was 5°C/min, the load was 49 mN, and the measurement was performed in a nitrogen atmosphere. As a result, the linear expansion coefficient was 14 ppm/°C.

**[Table 1]**

| Items | Example 1 | Example 2 | Example 3 | Comparative Example 1 | Comparative Example 2 | Comparative Example 3 |
|---|---|---|---|---|---|---|
| Copper circuit thickness (mm) | 0.5 | 1.0 | 2.0 | 0.5 | 1.0 | 2.0 |
| Resin portion thickness (mm) | 0.5 | 1.0 | 2.0 | - | - | - |
| Misalignment (µm) | 37 | 23 | 21 | 242 | 177 | 115 |
| Breakdown voltage (kV) | >10 | >10 | >10 | 4.0 | 5.5 | 3.5 |

As shown in Table 1, the circuit boards produced in Examples 1 to 3 exhibited a less degree of circuit misalignment and a higher dielectric breakdown voltage, as compared with the circuit boards produced in Comparative Examples 1 to 3. The cause for the difference is considered to be that the raise of insulation layer of the circuit board of the Examples is suppressed by the resin portion disposed at spaces between circuits, as shown in Fig. 7, whereas cracks are formed in the circuit board of the Comparative Examples at an insulation layer that is raised without a resin portion disposed at spaces between circuits, as shown in Fig. 8. It is also considered that the amount of misalignment is reduced in the circuit boards of the Examples because the circuits are fixed by the resin portion disposed at spaces therebetween.

### [Reference Signs]

- 1: Circuit
- 2: Resin portion
- 3: Circuit sheet
- 4: Substrate (heat spreader)
- 5: Insulation layer
- 10: Temporary base material
- 11: Circuit board
- 12: Crack
- 13: Bridge
- 14: Space after removal of bridge

## Claims

1. A circuit board production method, the method comprising a process of disposing a circuit sheet on a substrate, the circuit sheet comprising circuits and a resin portion disposed at spaces between the circuits.

2. The circuit board production method according to claim 1, further comprising, prior to the process of disposing the circuit sheet on the substrate, a process of preparing the circuit sheet comprising circuits and a resin portion disposed at spaces between the circuits, wherein the circuits do not have a bridge.

3. The circuit board production method according to claim 1 or claim 2, wherein the circuit sheet further comprising a resin portion that is disposed at an outer periphery of the circuits.

4. The circuit board production method according to any one of claim 1 to claim 3, wherein the resin portion has a linear expansion coefficient of from 10 ppm/K to 50 ppm/K.

5. The circuit board production method according to any one of claim 1 to claim 4, wherein the circuits have a thickness of 350 µm or more.

6. The circuit board production method according to any one of claim 1 to claim 5, further comprising a process of disposing an insulation layer between the circuit sheet and the substrate.

7. The circuit board production method according to claim 6, wherein the insulation layer is disposed at at least one of a surface of the circuit sheet that faces the substrate or a surface of the substrate that faces the circuit sheet.

8. The circuit board production method according to claim 6 or claim 7, wherein the insulation layer is disposed by bonding an insulation layer disposed at a surface of the circuit sheet that faces the substrate with an insulation layer disposed at a surface of the substrate that faces the circuit sheet.

9. The circuit board production method according to any one of claim 6 to claim 8, wherein the insulation layer is in a partially cured state prior to the process of disposing the circuit sheet on the substrate.

10. The circuit board production method according to any one of claim 6 to claim 9, wherein the insulation layer has a thickness that is the same as the thickness of the circuits or less than the thickness of the circuits.

11. A circuit sheet, comprising circuits and a resin portion disposed at spaces between the circuits.

12. The circuit sheet according to claim 11, wherein the circuits do not have a bridge.

13. The circuit sheet according to claim 11 or claim 12, further comprising a resin portion that is disposed at an outer periphery of the circuits.

14. The circuit sheet according to any one of claim 11 to claim 13, wherein the resin portion has a linear expansion coefficient of from 10 ppm/K to 50 ppm/K.

15. The circuit sheet according to any one of claim 11 to claim 14, wherein the circuits have a thickness of 350 µm or more.

16. The circuit sheet according to any one of claim 11 to claim 15, further comprising an insulation layer that is disposed at at least one surface of the circuit sheet.

17. The circuit sheet according to claim 16, wherein the insulation layer has a thickness that is less than a thickness of the circuits.

18. A circuit board, comprising a substrate and circuits that are disposed on the substrate and that are formed from the circuit sheet according to any one of claim 11 to claim 17.
